# EUROPEAN PATENT SPECIFICATION

(11) **EP 3 532 539 B1**
(45) Date of publication and mention of the grant of the patent: **19.01.2022**
(21) Application number: 17864804.4
(22) Date of filing: 27.10.2017
(51) Int. Cl.: C08K 7/24, C08K 3/38, C09K 5/14, C08L 79/08, C08J 5/00, C23C 16/01, C23C 16/04, C23C 16/34, C23C 16/44

(54) **COMPOSITE MATERIAL AND METHOD OF FORMING SAME, AND ELECTRICAL COMPONENT INCLUDING COMPOSITE MATERIAL**
VERBUNDSTOFF UND VERFAHREN ZUR HERSTELLUNG DAVON SOWIE ELEKTRISCHE KOMPONENTE MIT DEM VERBUNDSTOFF
MATÉRIAU COMPOSITE ET PROCÉDÉ DE FORMATION ASSOCIÉ, ET COMPOSANT ÉLECTRIQUE COMPRENANT LE MATÉRIAU COMPOSITE

(30) Priority: 28.10.2016 SG 10201609051X
(43) Date of publication of application: 04.09.2019
(73) Proprietor: Nanyang Technological University, Singapore 639798 (SG)
(72) Inventor: LOEBLEIN, Manuela, Singapore 639798 (SG); TSANG, Siu Hon, Singapore 639798 (SG); TEO, Hang Tong Edwin, Singapore 639798 (SG)
(74) Representative: Mewburn Ellis LLP
(86) International application number: PCT/SG2017/050540
(87) International publication number: WO 2018/080400

(56) References cited:
- WO-A1-2015/167950
- CN-A- 105 062 007
- CN-A- 105 062 007
- CN-A- 106 243 715
- YAN W et al.: "Polyimide nanocomposites with boron nitride-coated multi- walled carbon nanotubes for enhanced thermal conductivity and electrical insulation", J. Mater. Chem. A, vol. 2, no. 48 24 October 2014 (2014-10-24), pages 20958-20965, XP055480404, [retrieved on 2018-01-06]
- ZENG X et al.: "Ice-Templated Assembly Strategy to Construct 3D Boron Nitride Nanosheet Networks in Polymer Composites for Thermal Conductivity Improvement", Small, vol. 11, no. 46, 19 October 2015 (2015-10-19), pages 6205-6213, XP055599134, ISSN: 1613-6810, DOI: 10.1002/smll.201502173
- FANG H et al.: "Thermal, mechanical and dielectric properties of flexible BN foam and BN nanosheets reinforced polymer composites for electronic packaging application", Composites Part A: Applied Science and Manufacturing, vol. 100 25 April 2017 (2017-04-25), pages 71-80, XP055480407, [retrieved on 2018-01-06]
- LOEBLEIN M et al.: "Configurable Three-Dimensional Boron Nitride-Carbon Architecture and Its Tunable Electronic Behavior with Stable Thermal Performances", Small, vol. 10, no. 15 2 May 2014 (2014-05-02), pages 2992-2999, XP055414175, [retrieved on 2018-01-06]

## Description

### Cross-Reference To Related Application

This application claims the benefit of priority of Singapore patent application No. 10201609051X, filed 28 October 2016.

### Technical Field

Various embodiments relate to a composite material and a method of forming the composite material, and an electrical component including the composite material. The composite material includes an interconnected network having a material that is thermally conductive and electrically insulative, wherein the material includes a multilayer hexagonal boron nitride, and a polymer including a polyimide, wherein the interconnected network is about 0.3 vol% or less of the composite material.

### Background

Flexible electronics technology provides a non-rigid and versatile platform that has extended many conventional electronics into a large diversity of novel applications through the transfer of current available processes and components onto flexible platforms (some examples are the bionic eye, optic nerve, flexible battery, conformable RFID (radio-frequency identification) tags, displays and touch screens). Among those platforms, polyimides (PIs), being known for their high thermal stability, high modulus of elasticity and tensile strength, ease of fabrication and moldability, have become the material of choice and have demonstrated their application in various organic and flexible electronics, including dielectrics for high speed signal transmission, packaging (encapsulation), membrane materials and shielding materials/coatings.

However, similar to other polymeric materials, PI suffers drawbacks from its low thermal conductivity. For instance, its low thermal conductivity has resulted in a heat dissipation challenge for flexible high power electronics (for comparison, the thermal conductivity of crystalline silicon (Si) is in the range of 100 W/mK, whereas PI is in the range of 0.2 W/mK). This drastic difference in their thermal dissipation capability bears heavily on the designers of flexible devices. Inevitably, the performance of these devices will need to be throttled down to reduce power consumption in order to decrease the heat generated by their operation.

One way to mitigate this issue is to infuse higher thermal conductivity materials into the polymer matrix to improve its overall conductivity. Recently, there is a growing interest to use highly thermally conductive nanomaterials as "nanofillers" for infusing into the matrix. Typical nanomaterials of choice for electrically insulating filler needs are listed in Table 1 below.

**TABLE 1**

| Filler-type | Remarks |
|---|---|
| Aluminium oxide (Al₂O₃) | 4.3 W/mK at 60 vol% in epoxy, high dielectric constant |
| Silicon oxide (SiO₂) | Low thermal conductivity at 55-70 vol% in epoxy |
| Zinc oxide (ZnO) | High dielectric constant |
| Beryllium oxide (BeO) | High toxicity and cost |
| Aluminium nitride (AlN) | 11.5 and 11.0 W/mK at 60 vol% in polyvinyl fluoride (PVF) and epoxy, low oxidation resistance and high dielectric constant |
| Silicon nitride (Si₃N₄) | Moderate thermal conductivity |
| Silicon carbide (SiC) | High saturated carrier drift velocity, high dielectric constant |
| Graphene oxide (GO) | 4-fold thermal conductivity increase at 5 wt% in epoxy, easy to get reduced via low-temperature thermal treatment (which turns it to electrically conducting graphene) |
| Diamond | 4.1 W/mK at 68 vol% in epoxy, high cost, no superiority |
| Barium titanate (BaTiO₃) | 300% increase of thermal conductivity at 50 wt% in ethylene-vinyl acetate (EVA), high thermal conductivity, very high dielectric constant, high density |
| Boron nitride (BN) | High thermal conductivity |

One of the parameters to consider is the intrinsic thermal conductivity of the filler material, including, for example, in the manner the filler material is arranged, which may affect thermal conduction. For known fillers (e.g., diamond or diamond flakes), such fillers are not connected to each other; in other words, when these known fillers are mixed, for example, into a polymer, the fillers are separated from one another. There is therefore a gap between one individual filler to another individual filler with the polymer within the gap. Hence, for heat conduction between the two individual fillers, the polymer (which is low in thermal conductivity) in between the two fillers has to be overcome, thus leading to poor overall thermal conductivity. Other parameters to consider include the amount of filling required (high filler loading could deteriorate the mechanical and other properties of the composites, therefore it is important to develop conductive composites with low particle loading), and the dielectric constant (have similar electrical characteristics as the polymer matrix as otherwise electric field distortion could occur).

Among these nanofillers, BN was found to be a suitable filler for highly thermally conductive composites and ideal for electronic packaging application. It has high thermal conductivity, high electrical resistivity, low dielectric constant (matching to that of PI), high temperature resistance and low density.

CN 105062007 A discloses a high-thermal-conductivity polymer composite material and a preparation method and application thereof. The high-thermal-conductivity polymer composite material comprises a polymer base body and three-dimensional boron nitride arranged in the polymer base body in a filling mode. The volume fraction of the three-dimensional boron nitride in the high-thermal-conductivity polymer composite material is 5-50%. According to the high-thermal-conductivity polymer composite material, the three-dimensional boron nitride is adopted to build a three-dimensional network structure in the polymer base body. A heat conductive channel is built in the polymer base body. Thus, the high-thermal-conductivity polymer composite material has a high heat conductive coefficient, the condition of the preparation method of the material is moderate and easy to control, the technology is simple, and the method is safe and environmentally friendly.

WO 2015/167950 A1 discloses a thermally conductive composite including a polymer; and boron nitride, wherein the boron nitride is in a form of a nanofiber, a nanotube, a nanoplate, or a combination thereof. Alternatively, the thermally conductive composite includes a boron nitride comprising pores; and a polymer disposed in a pore of the boron nitride.

Yan W. et al, J. Mater. Chem. A 2, 20958-20965 (2014) discloses polyimide nanocomposites with boron nitride-coated multi-walled carbon nanotubes for enhanced thermal conductivity and electrical insulation.

Zeng X. et al. Small 11, 6205-6213 (2015) discloses an ice-templated assembly strategy to construct 3D boron nitride nanosheet networks in polymer composites for thermal conductivity improvement.

### Summary

The invention is defined in the independent claims. Further embodiments of the invention are defined in the dependent claims.

According to a first aspect of the invention, a composite material according to claim 1 is provided.

According to a second aspect of the invention, a method of forming a composite material according to claim 6 is provided.

According to a third aspect of the invention, an electrical component according to claim 14 is provided.

### Brief Description of the Drawings

In the drawings, like reference characters generally refer to like parts throughout the different views. The drawings are not necessarily to scale, emphasis instead generally being placed upon illustrating the principles of the invention. In the following description, various embodiments of the invention are described with reference to the following drawings, in which:
FIG. 1A shows a schematic diagram of a composite material, according to various embodiments.
FIG. 1B shows a flow chart illustrating a method of forming a composite material, according to various embodiments.
FIG. 1C shows a schematic cross-sectional view of an electrical component, according to various embodiments.
FIG. 2A shows an optical image of a three-dimensional boron nitride (3D-BN) material, according to various embodiments.
FIG. 2B shows a Raman spectrum of a three-dimensional boron nitride (3D-BN) material.
FIG. 3 shows an optical image of a three-dimensional boron nitride/polyimide (3D-BN/PI) composite, according to various embodiments. The scale bar represents 1 cm.
FIG. 4A shows a plot of laser flash thermal conductivity results.
FIG. 4B shows a plot of thermogravimetric analysis (TGA) thermal stability results.
FIG. 5 shows optical images illustrating the flexibility of a 3D-BN/PI film.
FIG. 6 shows an optical image of a printed electronic resistor on a 3D-BN/PI film. The scale bar represents 5 mm.
FIG. 7 shows thermal images of the heat spreading capabilities of 3D-BN/PI and known PI films.

### Detailed Description

The following detailed description refers to the accompanying drawings that show, by way of illustration, specific details and embodiments in which the invention may be practiced. These embodiments are described in sufficient detail to enable those skilled in the art to practice the invention. Other embodiments may be utilized and structural, logical, and electrical changes may be made within the scope defined by the appended claims. The various embodiments are not necessarily mutually exclusive, as some embodiments can be combined with one or more other embodiments to form new embodiments.

Embodiments described in the context of one of the methods or devices are analogously valid for the other methods or devices. Similarly, embodiments described in the context of a method are analogously valid for a device, and vice versa.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

In the context of various embodiments, the phrase "at least substantially" may include "exactly" and a reasonable variance.

In the context of various embodiments, the term "about" or "approximately" as applied to a numeric value encompasses the exact value and a reasonable variance.

As used herein, the term "and/or" includes any and all combinations of one or more of the associated listed items.

Various embodiments may provide a high thermal performance flexible polymer (e.g., polyimide or polyimide composite).

Various embodiments may provide a flexible dielectric high thermal performance 3D (three-dimensional) scaffold embedded polyimide for various applications.

Various embodiments may provide a material developed as part of an improved flexible electronic substrate. The material includes a three-dimensional hexagonal boron nitride (3D-BN) matrix infused within a polymer of the polyimide (PI) class via a multistep fabrication process. Various embodiments also provide a fabrication process for the hybrid 3D-BN/polyimide (3D-BN/PI) and the associated results.

Various embodiments may provide a method to fabricate three-dimensional hexagonal boron nitride infused polyimide (PI) composite (3D-BN/PI) via a multiple-step imidization approach. The 3D-BN network is an interconnected structure that includes multilayer hexagonal boron nitride (h-BN). As a result, with a filling factor of merely 0.3 vol% (0.35 wt%), the overall thermal conductivity of the nanocomposite PI film may improve by 25-times to 5 W/mK, while preserving the electrically insulating nature and flexibility of the polymer.

The hybrid film or composite film of various embodiments may be directly used as a substrate for flexible electronics. In various embodiments, an electronic resistor structure may be directly printed onto the 3D-BN/PI film using an ink-jet printer with a silver ink. In further embodiments, a hot spot may be created at the centre of a bare PI film and a 3D-BN/PI film and their heat dissipation may be monitored with a thermal camera to assess the corresponding thermal conductivity of both films. The results for the resistor structure and heat dissipation show that the 3D-BN/PI film is readily applicable as a flexible substrate with more efficient and uniform heat spreading capabilities.

Although improvements of the overall conductivity may be obtained using BN nanoparticles, there are still considerable challenges, such as inhomogeneous distribution of the nanofiller within the polymer matrix, aggregation and high filling fraction. Another critical concern is the poor long range thermal conduction seen in many of these composites as only a fraction of these individual nanomaterials are coupled together (weakly through Van der Waals forces) and most of the fillers are generally encapsulated entirely by the polymer matrix. Some examples using other kinds of BN nanofillers in PI are shown in Table 2 below.

**TABLE 2**

| Filler-type | Filling Fraction | | Thermal Conductivity^{a} [W/mK] |
|---|---|---|---|
| | vol% | wt% | |
| h-BN particles | 60 | - | 7 |
| Surface modified BN nanosheets | - | 30 | 1.2 |
| Titanate coupled BN nanosheets | - | 50 | 0.86 |
| Titanate coupled BN nanosheets + graphene | - | 50 + 1 | 2.1 |
| 3D-BN (various embodiments) | 0.3 | 0.35 | 5 |
| ^{a}Through-plane (z-direction) | | | |

High filling fractions may be required in order to obtain a continuous thermal transport path throughout the PI. However, this may lead to loss of the PI's mechanical properties, and may also cause breaking during fabrication. The film and method of various embodiments use intrinsically interconnected filler which (only) requires approximately 0.3 vol% (about 0.35 wt%) filling fraction to achieve a 25-fold thermal conductivity improvement over a bare PI material.

The use of h-BN (e.g., 3D-BN) may be contrasted against the use of known carbonaceous fillers such as graphene and also 3D-C (3D-graphene) as it preserves the electrically insulating behavior of the PI. This makes the 3D-BN/PI film directly applicable for flexible electronics substrate, meaning that it is not required to deposit an additional insulating layer before depositing electronic devices or elements or structures on 3D-BN/PI films, as is necessary for electronic devices or structures on a 3D-C/PI film (which is conductive, with a resistivity of 1 Ω.cm), which otherwise would cause short-circuit.

The 3D-BN/PI composite material or film may have one or more of the following: (1) high flexibility, (2) mechanically stable, (3) able to withstand several (or high number of) bending cycles, and (4) similar properties as bare PI.

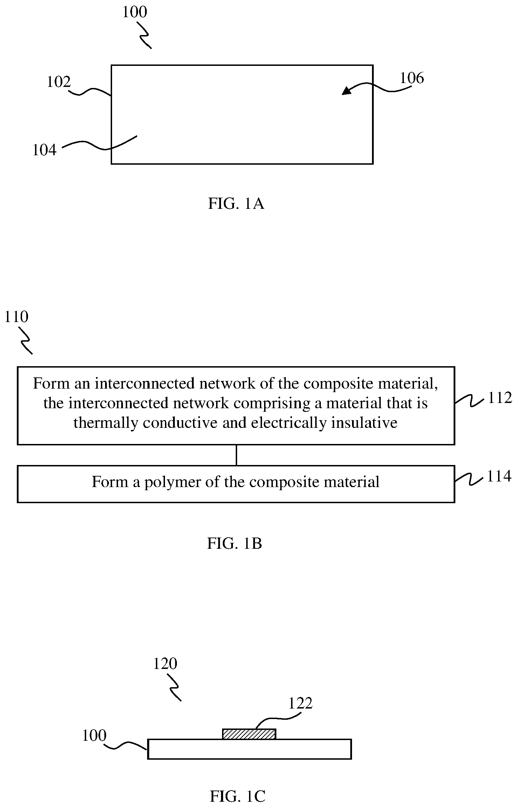

FIG. 1A shows a schematic diagram of a composite material 100, according to various embodiments. The composite material 100 includes an interconnected network 102 including a material 104 that is thermally conductive and electrically insulative, and a polymer 106.

In other words, a composite material 100 is provided. As may be appreciated, the term "composite material" means a material having at least two constituent materials. The composite material 100 includes an interlinked network structure 102, extending through or throughout the composite material 100. The interconnected network 102 extends three-dimensionally within the composite material 100, meaning that the interconnected network 102 is a three-dimensional (3D) interconnected network 102. The interconnected network 102 may act as a (3D) scaffold or a (3D) skeleton of the composite material 100. The interconnected network 102 may act as a filler material or structure for the composite material 100.

The interconnected network 102 includes or is made of a thermally conductive and electrically insulative material 104. As a result, heat may be conducted through the interconnected network 102. By including the interconnected network 102 of the material 104, which is thermally conductive, in the composite material 100, the composite material 100 is thermally conductive. As a result, heat may be conducted through the composite material 100.

The material 104 may extend seamlessly or continuously through the (entire) interconnected network 102. Respective parts of the interconnected network 102 including the material 104 may be (physically) connected to each other, seamlessly.

The composite material 100 further includes a polymer or a polymer matrix 106. This means that the composite material 100 includes a mixture of the interconnected network 102 and the polymer 106. The polymer 106 may be in contact with the interconnected network 102. The polymer 106 may be coated on the (surface of the) interconnected network 102. The polymer 106 may be integrated with the interconnected network 102.

The polymer 106 is electrically insulating or includes an electrically insulative polymer. Coupled with the interconnected network 102 of the material 104, which is electrically insulative, the composite material 100 is an electrical insulator, meaning that the composite material 100 is electrically insulative.

In various embodiments, the material 104 may have a thermal conductivity that is higher than a thermal conductivity of the polymer 106.

The material 104 may have a high thermal conductivity. In the context of various embodiments, the material 104 may have a thermal conductivity of between about 1 W/ m K and about 100 W/m K, for example, between about 1 W/m K and about 80 W/m K, between about 1 W/m K and about 50 W/m K, between about 1 W/m K and about 20 W/m K, between about 1 W/m K and about 10 W/m K, between about 10 W/m K and about 100 W/m K, between about 50 W/m K and about 100 W/m K, or between about 20 W/m K and about 50 W/m K. It should be appreciated that the thermal conductivity may depend on the density of the material 104.

The material 104 may have a high electrical resistivity or electrical resistance. In the context of various embodiments, the material 104 may have an electrical resistance of about 10 kΩ or more (i.e., ≥10 kΩ), for example, ≥20 kΩ or ≥50 kΩ, e.g., an electrical resistivity of about 10 kΩ, about 15 kΩ, about 20 kΩ, about 30 kΩ, or about 50 kΩ.

In various embodiments, the interconnected network 102 may be infiltrated (or infused) with the polymer 106.

In various embodiments, the interconnected network 102 may be embedded within the polymer 106. This may mean that the interconnected network 102 may be surrounded or enclosed or encapsulated by the polymer 106. The entire interconnected network 102 may be embedded within the polymer 106.

Respective dielectric constants of the material 104 and the polymer 106 may be at least substantially similar. This may mean that the dielectric constant of the material 104 may be at least substantially matching the dielectric constant of the polymer 106.

The electrical resistance (or resistivity) of the polymer 106 may be at least substantially similar to or less than the electrical resistance (or resistivity) of the material 104. This may mean : electrical resistance (or resistivity) of the polymer 106 ≤ electrical resistance (or resistivity) of the material 104.

In various embodiments, the interconnected network 102 may include a porous network structure. This may mean that the interconnected network 102 may have a foam-like structure. The polymer 106 may penetrate or permeate into and/or through the pores of the porous network structure.

In various embodiments not covered by the claimed invention, the material 104 may include a ceramic.

In the context of various embodiments, the material 104 includes hexagonal boron nitride (h-BN). This means that the interconnected network 102 is a three-dimensional hexagonal boron nitride (3D-BN) which acts as an electrically insulative 3D scaffold material. A hexagonal boron nitride (h-BN) means a layered structure having a network of (BN)₃. Accordingly, the interconnected network 102 includes an interconnected structure having a multilayer h-BN.

As mentioned, known fillers remain separated from one another when mixed in a polymer. In contrast, for the interconnected network 102 with the material 104 (e.g., 3D-BN), the whole structure is interconnected. This means that heat may be conducted from one point of the interconnected network 102 to another point of the interconnected network 102 (including between two ends of the interconnected network 102), where the phonon may just propagate or move through the interconnected network 102 (e.g., 3D-BN network) which may act as an "expressway" for the heat and bypassing the polymer 106, which, in contrast, may offer a low thermal conductivity path.

In various embodiments, the interconnected network 102 is about 0.3 vol% or less of the composite material. This means that the amount or filling fraction of the interconnected network 102 is ≤ 0.30 vol%, for example, ≤ 0.25 vol%, ≤ 0.20 vol%, ≤ 0.15 vol%, or ≤ 0.10 vol%, e.g., about 0.30 vol%. The amount or filling fraction of the interconnected network 102 provided in the composite material 100 may depend on the needs or requirements of the intended applications, where a higher filling fraction may result in a higher or better thermal conductivity of the (whole) composite material (or film) 100. It should be appreciated that in further embodiments not covered by the claimed invention, the amount or filling fraction of the interconnected network 102 may be more than 0.30 vol% (i.e., > 0.30 vol%). However, it should be appreciated that having a low filling fraction (e.g., ≤ 0.30 vol%) assists in minimizing any potential adverse effect on the composite material, where a higher filling fraction may potentially deteriorate the mechanical and other properties of the composite material.

In various embodiments, the polymer 106 may be flexible. As a result, the composite material 100 may be a flexible composite material.

In various embodiments, the polymer 106 includes a polyimide (PI). This means that the composite material 100 is a polyimide-based composite material. Polyimide (PI) is suitably used for or as a flexible substrate due to its relatively high thermal stability. However, in embodiments not covered by the claimed invention, it should be appreciated that the polymer (or polymer matrix) 106 may be any type of polymer or polymeric film.

In various embodiments, the composite material 100 includes a hybrid interconnected network of hexagonal boron nitride and polyimide (3D-BN/PI).

In the context of various embodiments, the composite material 100 may be in the form of a film.

In the context of various embodiments, the composite material 100 may be a freestanding structure.

In the context of various embodiments, having an interconnected network (e.g., 3D-BN) in the composite material provides one or more (continuous) paths for long range thermal conduction, thereby allowing heat to be conducted seamlessly across the (entire) composite material. Further, the incorporation of an interconnected network enables a low filling factor of the material relative to the polymer, which helps to preserve the polymer's intrinsic properties, as otherwise a high filling factor may lead to deterioration of the polymer's mechanical properties and may result in breakage of the composite material.

FIG. 1B shows a flow chart 110 illustrating a method of forming a composite material, according to various embodiments.

At 112, an interconnected network of the composite material is formed, the interconnected network including a material that is thermally conductive and electrically insulative.

At 114, a polymer of the composite material is formed.

In various embodiments, at 114, the polymer may be infiltrated into the interconnected network.

In various embodiments, at 114, the interconnected network may be embedded within the polymer.

In various embodiments, at 112, a chemical vapour deposition (CVD) process may be carried out to form the interconnected network. The CVD process may be a template-directed CVD process. The CVD process may be performed in a furnace.

In various embodiments, for the CVD process, one or more precursors for (or of) the material may be supplied to a supporting template (or structure) to form the interconnected network on the supporting template. The interconnected network that is formed may conform to the structure or configuration of the supporting template. As a non-limiting example, the supporting template may be positioned in a furnace and subsequently, the precursor(s) may be provided into the furnace towards the supporting template. The precursor(s) and the supporting template may be subjected to heating during the CVD process. The supporting template may be annealed prior to the precursor(s) being supplied to the supporting template.

The one or more precursors may react and/or decompose on the supporting template to form the material of the interconnected network. The precursor(s) may be volatile or gaseous. The precursor(s) may be supplied with or in a carrier gas (e.g., hydrogen (H₂)).

The supporting template may act as a catalytic substrate. The supporting template may have a porous structure or a foam-like structure. The supporting template may be or may include a metal, meaning a metal support. Non-limiting examples include nickel (Ni) or copper (Cu), which may have a foam-like structure.

In various embodiments, the supporting template may be removed. After forming the interconnected network on the supporting template, the supporting template may subsequently be removed, for example, via etching or use of an etchant. Where a metal supporting template is used, a metal etchant such as an acid (e.g., hydrochloric acid (HCl) or nitric acid (HNO₃)) may be used.

In various embodiments, a protective layer may be formed on the interconnected network on the supporting template prior to removing the supporting template. The protective layer may protect the interconnected network or the material thereof during the removal of the supporting template, for example, from chemical reaction or attack by the etchant used to etch the supporting template. The protective layer may be subsequently removed after removal of the supporting template. The protective layer may include a polymer, for example, poly(methyl methacrylate) (PMMA) or polydimethylsiloxane (PDMS).

In various embodiments, the material includes hexagonal boron nitride (h-BN). A non-limiting example of the precursor corresponding to boron nitride may include sublimated ammonia-borane (NH₃-BH₃) powder.

In various embodiments, the polymer may be flexible.

In various embodiments, the polymer includes a polyimide (PI).

In various embodiments, at 114, to form the polymer (i.e., polyimide), a (or at least one) processing stage may be performed, including supplying a precursor for (or of) the polyimide on the interconnected network, and imidizing the precursor to form the polyimide. This may mean subjecting the precursor (for the PI) to an imidization process to convert the precursor to the polyimide. As a result of carrying out the processing stage, a layer of polyimide may be formed.

The precursor may be in the form of a solution, which may be poured onto the interconnected network. In various embodiments, the precursor may include, but not limited to, polyamic acid (PAA) (e.g., a PAA solution).

The imidization process may include a thermal imidization process, meaning that a heating process may be carried out to convert or cure the precursor into the polyimide. The heating process may be carried out in an inert environment, for example, in an argon (Ar) or nitrogen (N₂) atmosphere. The heating process for the curing process may be carried out at a temperature of between about 300°C and about 400°C.

In various embodiments, at 114 (FIG. 1B), a plurality of the processing stages may be performed successively. The processing stages may result in the formation of a plurality of layers of polyimide successively, one over (or on top of) the other. By way of illustration, a solution including a polyamic acid (PAA) and a solvent (e.g., N-Methyl-2-pyrrolidone (NMP)) - meaning diluted PAA - may be supplied or provided on the interconnected network, in each processing stage prior to a final processing stage, in (gradual) decreasing dilution level of PAA (i.e., the diluted PAA solution containing increasing amount of PAA) for each successive processing stage. In the first processing stage, the solution may include PAA to NMP at a ratio of 1:3. In the final processing stage, an undiluted PAA solution (without NMP) may be supplied on the interconnected network. In various embodiments, it should be appreciated that the dilution level of PAA may be gradually decreased (or conversely, the concentration of PAA may be gradually increased) for each successive processing stage until eventually the concentration of PAA reaches 100%.

As a non-limiting example, the interconnected network may be provided or positioned on a substrate or carrier (e.g., a silicon (Si) wafer with a thermal oxide layer (SiO₂) or a quartz substrate) prior to the processing stage(s) being carried out. The substrate may be removed at the end when the composite material (in the final form) has been formed, for example, by peeling off the composite material from the substrate.

While the method described above is illustrated and described as a series of steps or events, it will be appreciated that any ordering of such steps or events are not to be interpreted in a limiting sense. For example, some steps may occur in different orders and/or concurrently with other steps or events apart from those illustrated and/or described herein. In addition, not all illustrated steps may be required to implement one or more aspects or embodiments described herein. Also, one or more of the steps depicted herein may be carried out in one or more separate acts and/or phases.

FIG. 1C shows a schematic cross-sectional view of an electrical component 120, according to various embodiments. The electrical component 120 includes the composite material 100, and an electrical element 122 on the composite material 100. The composite material 100 may act as or may be part of a substrate for the electrical element 122. The composite material 100 is electrically insulative. The composite material 100 is as described in the context of FIG. 1A. The electrical component 120 may be part of an electrical device.

The electrical element 122 may be formed on the composite material 100, for example, being (directly) printed on the composite material 100.

In various embodiments, the composite material 100 may be flexible. This may mean that the electrical component 120 may be a flexible electrical component, suitable for flexible electronics applications.

The electrical component 120 may be free of an (electrical) insulator between the electrical element 122 and the composite material 100.

The electrical element 122 may be in contact with the composite material 100. This may mean that the electrical element 122 may be directly on the composite material 100, without any intermediate material therebetween. This may also mean there is absence of coating or surface functionalization on the composite material 100 where the electrical element 122 is provided or formed.

As non-limiting examples, the electrical element 122 may include a resistor, an electrode, an electrical conduction path, etc.

It should be appreciated that descriptions in the context of the composite material 100 may correspondingly be applicable in relation to the method of forming a composite material described in the context of the flow chart 110 and the electrical component 120, and vice versa.

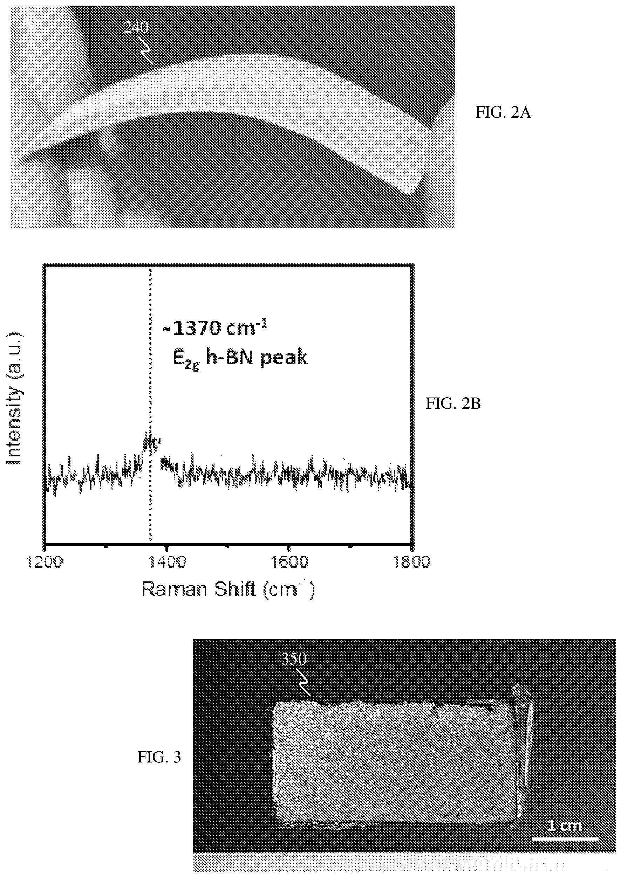

Various embodiments are based on the integration of three-dimensional h-BN into polyimide ("3D-BN/PI"). An example of a three-dimensional boron nitride (3D-BN) structure or film is as shown in the optical image of FIG. 2A illustrating a 3D-BN bare foam 240. As may be observed, the 3D-BN material 240 is flexible and may be bent or curved. Such a structure may be obtained through chemical vapor deposition (CVD), but it should be appreciated that it is not limited to this fabrication method.

### Preparation of 3D-BN

As a non-limiting example, the 3D-BN may be obtained via a CVD process, as will be described below, but various embodiments are not limited to 3D-BN structures made from CVD. While CVD may be a preferable or optimum approach for various embodiments, other suitable methods may be employed to obtain 3D-BN, for example, freeze-drying of nano BN flakes.

By way of examples, in a CVD process (e.g., template-directed thermal chemical vapor deposition (TCVD)), 3D-BN structures or foams may be obtained or fabricated using a foam-like metal (e.g., nickel (Ni), copper (Cu), etc.) template as a substrate or supporting structure (e.g., as a catalytic substrate). The CVD process may be carried out in an apparatus or furnace suitable for CVD (e.g., a split tube furnace). After annealing the substrate (for example, at about 1000°C for a duration of between about 15 minutes and about 30 minutes), a corresponding precursor (e.g., precursor gas) may be led or supplied into the furnace together with hydrogen (H₂) in order to decompose the precursor into boron (B) and nitrogen (N) atoms for forming h-BN. The precursor may be decomposed on or onto the surface of the metal template. An example of a precursor gas that may be employed may include, but not limited to, sublimated ammonia-borane (NH₃-BH₃) powder. After growth is terminated, the metal template has to be etched. For this, the h-BN may be protected with a protective layer, for example, a polymer including but not limited to, poly(methyl methacrylate) (PMMA). Subsequently, the resulting structure may be submerged into a metal etchant, for example, an acid (e.g., hydrochloric acid (HCl), nitric acid (HNO₃), etc.) until complete removal of the metal support, which may take a few hours. The protective layer may then be removed, which, for example for PMMA, may be via the use of acetone or an annealing process (for example, at about 700°C for about 1 hour in an inert gas environment (e.g., argon (Ar) or nitrogen (N₂)). After removing the protective layer, the result is a freestanding, ultra-light weight h-BN foam (or freestanding 3D-BN). The obtained 3D-BN foam may be a porous structure.

In order to verify the presence and crystallinity of the obtained h-BN (3D-BN), Raman spectroscopy may be used. FIG. 2B shows a Raman spectrum of 3D-BN with its signature peak at ∼1370 cm⁻¹ demarcated therein.

### Preparation of 3D-BN/PI nanocomposite

To form the 3D-BN/PI composite, as non-limiting examples, the 3D-BN structure may be positioned on a carrier, for example, a silicon (Si) wafer with a thermal oxide layer (SiO₂) or a Quartz substrate. A polyimide (PI) precursor, for example, a solution of polymer matrix precursor for polyimide (PI), such as polyamic acid (PAA), may be employed. First, a solution of polyamic acid (PAA) diluted with N-Methyl-2-pyrrolidone (NMP) at a ratio of 1:3 may be poured on the surface of the 3D-BN material. The PAA-3D-BN system or composition may then be heated in an inert (e.g., argon (Ar) or nitrogen (N₂)) environment, which may cure the PAA solution into polyimide (PI). The curing process may be carried out at a temperature of between about 300°C and about 400°C. Depending on the total thickness of the final film desired, this step may be repeated a number of times with a gradual decrease of dilution level of the PAA each time. As a final step, an additional layer of undiluted PAA solution may be poured on the sample and cured (for example, based on the curing process described above). Finally, the 3D-BN infused PI or 3D-BN/PI film may be obtained by peeling off the composite material from the substrate. The result is a freestanding 3D-BN/PI film or structure. FIG. 3 shows an optical image of an obtained three-dimensional boron nitride/polyimide (3D-BN/PI) composite 350 of 120 µm thickness.

As described, it should be appreciated that a bare 3D-BN foam may be formed into a foam-infused PI (3D-BN/PI) via multiple-step imidization. The number of pouring/curing steps for PAA may depend on the final thickness desired for the cured PI.

### Results of the nanocomposite film

Characterizations carried out include electrical and thermal conductivity, thermogravimetric analysis (TGA) and flexibility tests. By way of examples, to demonstrate the characteristics of the 3D-BN/PI composite of various embodiments, an electronic resistor structure was directly printed onto the film, and hot spots were created at the centers of the 3D-BN/PI film and a known (bare) PI film and their spread were observed under a thermal camera.

Electrical resistivity on the 3D-BN/PI film may be measured using the 4-point Van der Pauw method, which reveals an electrical resistivity, p, of ~1.3 GΩ.cm, which corresponds to an insulating material (for reference, the resistivity, p, for a bare PI is ∼1.5 GΩ.cm, which is in the same range as the 3D-BN/PI).

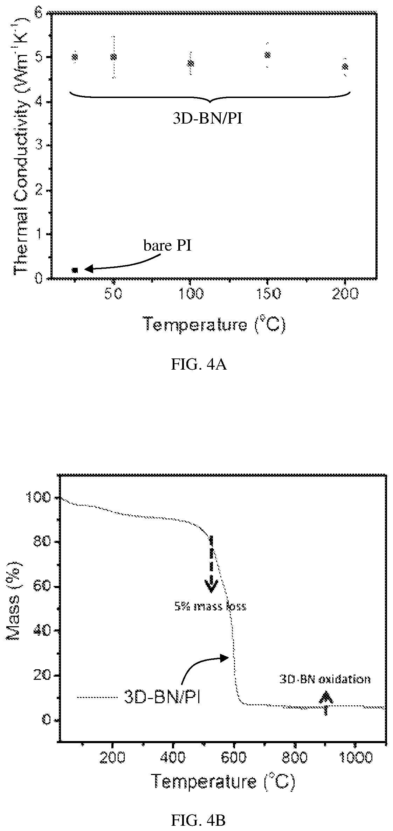

Thermal conductivity of the 3D-BN infused PI may be measured using the laser flash method. A temperature range from room temperature to about 200°C may be chosen in order to verify the stability of the material's thermal performance throughout the typical operating temperature ranges of electronics. FIG. 4A shows the thermal conductivity results obtained using the laser flash method, which as may be observed, clearly highlights the extreme or significant increase in thermal conductivity obtained for the 3D-BN/PI material or film. For comparison, the thermal conductivity for a pure PI is demarcated (0.2 W/mK) in FIG. 4A. As shown, the thermal conductivity of the hybridized PI with merely a filling fraction of approximately 0.3 vol% (0.35 wt%) of 3D-BN is in the order of 5 W/mK throughout the temperature range, which corresponds to a 25-fold increase. In various embodiments, the filling fraction (e.g., 0.3 vol%) of 3D-BN may be determined based on the initial porosity of the 3D-BN structure.

The thermal performance may also be measured through TGA, which determines the composite's stability throughout a temperature range, for example, from room temperature to about 1100°C, via monitoring its weight while exposed to dry air.

FIG. 4B shows the curve obtained from the TGA. The point of 5% mass loss determines the decomposition temperature of the composite film, which means the point up to which the material remains stable. For 3D-BN/PI, it is measured to be at ∼520°C, which is in agreement with the obtained values of pure PI. The curve also corroborates the mass proportions of 3D-BN and PI in the hybrid film: while, at 520°C, the mass reduces by almost 93%, at ~900°C, which is the point of BN oxidation to B₂O₃, the mass only increases by 0.6%, in accordance to the 0.3% filling fraction. The remaining mass % is due to residues from the PI.

In order to corroborate the 3D-BN/PI's stability up to 500°C, the electrical conductivity of the sample may be measured after having heated the sample up to 500°C for one hour. The result demonstrates that the film remains stable with an electrical resistivity, p, of about 1.3 GΩ.cm.

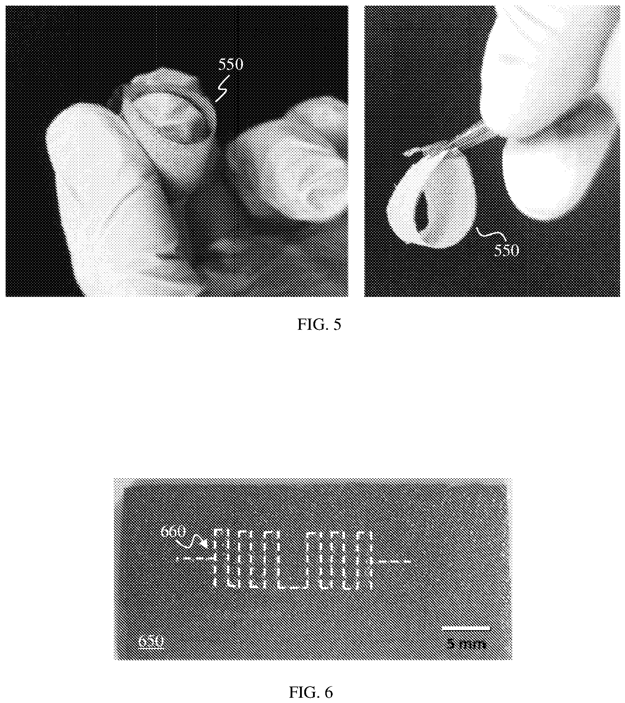

In order to verify the flexibility of the composite PI (3D-BN/PI), a qualitative study may be carried out via repetitive bending of the polymer. FIG. 5 shows optical images illustrating the flexibility of a 3D-BN/PI film 550, showing an example of such bending. It may be observed that no damage is caused to the PI's initial flexibility. The 3D-BN/PI film may be bent several times without breaking (shown in FIG. 5 after 50 times rolling/bending).

In order to demonstrate the composite film's direct applicability as a flexible substrate, an electronic resistor structure may be printed using ink jet printing with a silver (Ag) ink. FIG. 6 shows an optical image of a printed electronic resistor (configuration/shape of the resistor superimposed with the dashed line 660 for clarity) on a 3D-BN/PI film 650. In contrast to known PI films, the 3D-BN/PI film may not require any prior surface modification in order to obtain good adhesion of the ink onto the surface. Further, due to the electrically insulating nature of the 3D-BN/PI composite, electronic structures may be formed or provided directly on the 3D-BN/PI composite or a surface thereof, without the need for a separate insulating layer between the electronic structures and the 3D-BN/PI composite (or film) of various embodiments.

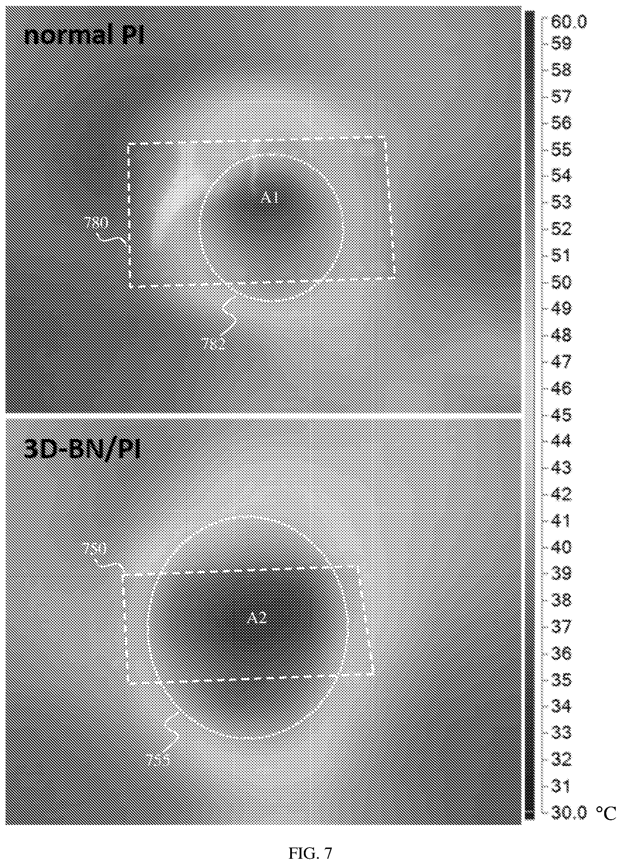

In order to demonstrate the improved heat spreading capability of the 3D-BN/PI film of various embodiments, a hot spot of approximately 60°C may be created at the center of respective films (e.g., 2 cm × 3 cm) of bare PI and hybridized/composite PI of the same thickness. The evolution of temperature (e.g., in terms of time and/or spread through the films) may be observed under a thermal camera. FIG. 7 shows thermal images of the heat spreading capabilities of 3D-BN/PI and known PI films, showing the images obtained after 5 minutes of constant contact with the heat source.

It may be clearly seen that, for the case of the known bare PI film (boundary of the film superimposed with the dashed box 780), the heat remains confined within its point of generation (in the vicinity of "A1") even after 5 minutes of constant contact with the external heat source, with the heat spread generally within the dashed circle 782. The temperature is about 60°C at "A1", and decreasing in a direction away from "A1" to a temperature of about 30°C external to the PI film. Contrastingly, the 3D-BN/PI film (boundary of the film superimposed with the dashed box 750) may be able to spread the heat along the entire film (as illustrated by the dashed circle 755) in a radial pattern away from the hot spot (in the vicinity of "A2"). It may be noted that this may already be observable for the 3D-BN/PI film even after a short exposure to the heat source. There is therefore improved heat spreading capability of the 3D-BN/PI material as compared to a bare PI. The heat spread may help in alleviating thermal issues as confined heat in single spots may lead to stress within the sample and thermal management issues, and, further, the spread may allow fast propagation of heat along the film, thus, providing efficient extraction of unwanted heat towards cooling sections in flexible electronic applications.

The 3D-BN/PI composite material may be used in various (commercial) applications in the following non-limiting fields.

Flexible electronics: The constantly increasing working temperatures of electronics limits the currently used PIs since their thermal conductivity is very low, which easily causes over-heating and reduces the maximum power applicable. The 3D-BN/PI film according to various embodiments may directly replace current PIs without the need for changing production and fabrication steps, since due to the very low filling fraction of 3D-BN, most or all of the PI's intrinsic properties may be preserved and the film's appearance and handling may remain unchanged. The 3D-BN/PI film have a direct use as a flexible electronics substrate. As may be seen in FIG. 6, electronic structures may be printed on the 3D-BN/PI film. No prior functionalization of the surface of the film may be necessary, and/or no coating of the surface of the film may be required.

Wearable technology: Flexible electronics and wearable electronics go hand-in-hand. Wearable technology requires flexible substrates, and as described herein, the 3D-BN/PI composite material may directly replace the currently used PI substrates. The described technology may be a key area for future development and market. The implications and applications of wearable technology are far reaching and may affect the fields of health and medicine, fitness, aging, disability, education, transportation, business, finance, games and music.

High temperature applications: h-BN and h-BN composites are suitable materials for special applications at high temperatures. Since, similarly to its bare counterpart, 3D-BN/PI remains stable even at elevated temperatures (up to ~500°C), it may be used in applications which require operational reliability at elevated temperatures.

The scope of the invention is indicated by the appended claims.

## Claims

1. A composite material (100, 350, 550) comprising:
an interconnected network (102) comprising a material (104) that is thermally conductive and electrically insulative, wherein the material (104) comprises a multilayer hexagonal boron nitride; and
a polymer (106) comprising a polyimide,
wherein the interconnected network (102) is about 0.3 vol% or less of the composite material (100, 350, 550).

2. The composite material (100, 350, 550) as claimed in claim 1, wherein the interconnected network (102) is infiltrated with the polymer (106).

3. The composite material (100, 350, 550) as claimed in claim 1 or 2, wherein the interconnected network (102) is embedded within the polymer (106).

4. The composite material (100, 350, 550) as claimed in any one of claims 1 to 3, wherein the interconnected network (102) comprises a porous network structure.

5. The composite material (100, 350, 550) as claimed in any one of claims 1 to 4, wherein the polymer (106) is flexible.

6. A method of forming a composite material (100, 350, 550), the method comprising:
forming an interconnected network (102) of the composite material (100, 350, 550), the interconnected network (102) comprising a material (104) that is thermally conductive and electrically insulative, wherein the material (104) comprises a multilayer hexagonal boron nitride, and wherein the interconnected network (102) is about 0.3 vol% or less of the composite material (100, 350, 550); and
forming a polymer (106) of the composite material (100, 350, 550), wherein the polymer (106) comprises a polyimide.

7. The method as claimed in claim 6, wherein forming a polymer (106) comprises infiltrating the polymer (106) into the interconnected network (102).

8. The method as claimed in claim 6 or 7, wherein forming a polymer (106) comprises embedding the interconnected network (102) within the polymer (106).

9. The method as claimed in any one of claims 6 to 8, wherein forming an interconnected network (102) comprises performing a chemical vapour deposition process to form the interconnected network (102).

10. The method as claimed in claim 9, wherein performing a chemical vapour deposition process comprises supplying one or more precursors for the material (104) to a supporting template to form the interconnected network (102) on the supporting template, and, optionally, the method further comprises removing the supporting template.

11. The method as claimed in any one of claims 6 to 10, wherein the polymer (106) is flexible.

12. The method as claimed in any one of claims 6 to 11, wherein forming a polymer (106) comprises:
performing a processing stage comprising:
supplying a precursor for the polyimide (106) on the interconnected network (102); and
imidizing the precursor to form the polyimide.

13. The method as claimed in claim 12, wherein performing a processing stage comprises performing a plurality of the processing stages successively.

14. An electrical component (120) comprising:
the composite material (100, 650) as claimed in any one of claims 1 to 5; and
an electrical element (122, 660) on the composite material (100, 650).

15. The electrical component as claimed in claim 14, wherein the electrical component (120) is free of an insulator between the electrical element (122, 660) and the composite material (100, 650), and/or wherein the electrical element (122, 660) is in contact with the composite material (100, 650).

## Patentansprüche

1. Verbundmaterial (100, 350, 550), das Folgendes umfasst:
ein Verbundnetzwerk (102), das ein Material (104) umfasst, das wärmeleitfähig und elektrisch isolierend ist, wobei das Material (104) ein mehrschichtiges hexagonales Bornitrid umfasst; und
ein Polymer (106), das ein Polyimid umfasst,
wobei das Verbundnetzwerk (102) etwa 0,3 Vol.-% oder weniger des Verbundmaterials (100, 350, 550) ausmacht.

2. Verbundmaterial (100, 350, 550) nach Anspruch 1, wobei das Verbundnetzwerk (102) mit dem Polymer (106) infiltriert wird.

3. Verbundmaterial (100, 350, 550) nach Anspruch 1 oder 2, wobei das Verbundnetzwerk (102) in das Polymer (106) eingebettet ist.

4. Verbundmaterial (100, 350, 550) nach einem der Ansprüche 1 bis 3, wobei das Verbundnetzwerk (102) eine poröse Netzwerkstruktur umfasst.

5. Verbundmaterial (100, 350, 550) nach einem der Ansprüche 1 bis 4, wobei das Polymer (106) flexibel ist.

6. Verfahren zur Ausbildung eines Verbundmaterials (100, 350, 550), wobei das Verfahren Folgendes umfasst:
das Ausbilden eines Verbundnetzwerks (102) aus dem Verbundmaterial (100, 350, 550), wobei das Verbundnetzwerk (102) ein Material (104) umfasst, das wärmeleitfähig und elektrisch isolierend ist, wobei das Material (104) ein mehrschichtiges hexagonales Bornitrid umfasst, und wobei das Verbundnetzwerk (102) etwa 0,3 Vol.-% oder weniger des Verbundmaterials (100, 350, 550) ist; und
das Ausbilden eines Polymers (106) des Verbundmaterials (100, 350, 550), wobei das Polymer (106) ein Polyimid umfasst.

7. Verfahren nach Anspruch 6, wobei das Ausbilden eines Polymers (106) das Infiltrieren des Polymers (106) in das Verbundnetzwerk (102) umfasst.

8. Verfahren nach Anspruch 6 oder 7, wobei das Ausbilden eines Polymers (106) das Einbetten des Verbundnetzwerks (102) in das Polymer (106) umfasst.

9. Verfahren nach einem der Ansprüche 6 bis 8, wobei das Ausbilden eines Verbundnetzwerks (102) das Durchführen eines chemischen Dampfabscheidungsverfahrens zur Ausbildung des Verbundnetzwerks (102) umfasst.

10. Verfahren nach Anspruch 9, wobei das Durchführen eines chemischen Dampfabscheidungsverfahrens das Zuführen eines oder mehrerer Vorläufer für das Material (104) zu einer Trägermatrix zur Ausbildung des Verbundnetzwerks (102) auf der Trägermatrix umfasst, wobei das Verfahren gegebenenfalls außerdem das Entfernen der Trägermatrix umfasst.

11. Verfahren nach einem der Ansprüche 6 bis 10, wobei das Polymer (106) flexibel ist.

12. Verfahren nach einem der Ansprüche 6 bis 11, wobei das Ausbilden eines Polymers (106) Folgendes umfasst:
das Durchführen einer Verarbeitungsstufe, die Folgendes umfasst:
das Zuführen eines Vorläufers für das Polyimid (106) auf das Verbundnetzwerk (102) und
das Imidisieren des Vorläufers zum Ausbilden des Polyimids.

13. Verfahren nach Anspruch 12, wobei das Durchführen einer Verarbeitungsstufe das Durchführen einer Vielzahl von Verarbeitungsstufen nacheinander umfasst.

14. Elektrisches Bauteil (120), das Folgendes umfasst:
ein Verbundmaterial (100, 650) nach einem der Ansprüche 1 bis 5 und
ein elektrisches Element (122, 660) auf dem Verbundmaterial (100, 650).

15. Elektrisches Bauteil nach Anspruch 14, wobei das elektrische Bauteil (120) frei von einem Isolator zwischen dem elektrischen Element (122, 660) und dem Verbundmaterial (100, 650) ist und/oder wobei das elektrische Element (122, 660) mit dem Verbundmaterial (100, 650) in Kontakt steht.

## Revendications

1. Matériau composite (100, 350, 550) comprenant :
un réseau interconnecté (102) comprenant un matériau (104) qui est thermiquement conducteur et électriquement isolant, dans lequel le matériau (104) comprend un nitrure de bore hexagonal multicouche ; et
un polymère (106) comprenant un polyimide,
dans lequel le réseau interconnecté (102) représente environ 0,3 % en volume ou moins du matériau composite (100, 350, 550).

2. Matériau composite (100, 350, 550) selon la revendication 1, dans lequel le réseau interconnecté (102) est infiltré avec le polymère (106).

3. Matériau composite (100, 350, 550) selon la revendication 1 ou 2, dans lequel le réseau interconnecté (102) est incorporé à l'intérieur du polymère (106).

4. Matériau composite (100, 350, 550) selon l'une quelconque des revendications 1 à 3, dans lequel le réseau interconnecté (102) comprend une structure de réseau poreuse.

5. Matériau composite (100, 350, 550) selon l'une quelconque des revendications 1 à 4, dans lequel le polymère (106) est flexible.

6. Procédé de formation d'un matériau composite (100, 350, 550), le procédé comprenant les étapes consistant à :
former un réseau interconnecté (102) du matériau composite (100, 350, 550), le réseau interconnecté (102) comprenant un matériau (104) qui est thermiquement conducteur et électriquement isolant, dans lequel le matériau (104) comprend un nitrure de bore hexagonal multicouche, et dans lequel le réseau interconnecté (102) représente environ 0,3 % en volume ou moins du matériau composite (100, 350, 550) ; et
former un polymère (106) du matériau composite (100, 350, 550), dans lequel le polymère (106) comprend un polyimide.

7. Procédé selon la revendication 6, dans lequel la formation d'un polymère (106) comprend une infiltration du polymère (106) dans le réseau interconnecté (102).

8. Procédé selon la revendication 6 ou 7, dans lequel la formation d'un polymère (106) comprend l'incorporation du réseau interconnecté (102) à l'intérieur du polymère (106).

9. Procédé selon l'une quelconque des revendications 6 à 8, dans lequel la formation d'un réseau interconnecté (102) comprend une mise en œuvre d'un processus de dépôt chimique en phase vapeur pour former le réseau interconnecté (102) .

10. Procédé selon la revendication 9, dans lequel la mise en œuvre d'un processus de dépôt chimique en phase vapeur comprend une fourniture d'un ou plusieurs précurseurs pour le matériau (104) à un gabarit de support afin de former le réseau interconnecté (102) sur le gabarit de support et, facultativement, le procédé comprend en outre un retrait du gabarit de support.

11. Procédé selon l'une quelconque des revendications 6 à 10, dans lequel le polymère (106) est flexible.

12. Procédé selon l'une quelconque des revendications 6 à 11, dans lequel la formation d'un polymère (106) comprend les étapes consistant à :
mettre en œuvre une étape de traitement comprenant :
une fourniture d'un précurseur pour le polyimide (106) sur le réseau interconnecté (102) ; et
imider le précurseur pour former le polyimide.

13. Procédé selon la revendication 12, dans lequel la mise en œuvre d'une étape de traitement comprend une mise en œuvre d'une pluralité des étapes de traitement successivement.

14. Composant électrique (120) comprenant :
le matériau composite (100, 650) selon l'une quelconque des revendications 1 à 5 ; et
un élément électrique (122, 660) sur le matériau composite (100, 650).

15. Composant électrique selon la revendication 14, dans lequel le composant électrique (120) est exempt d'un isolant entre l'élément électrique (122, 660) et le matériau composite (100, 650), et/ou dans lequel l'élément électrique (122, 660) est en contact avec le matériau composite (100, 650) .
